(19)

**Europäisches Patentamt**
**European Patent Office**
**Office européen des brevets**

(11) **EP 3 844 819 B1**

(12) **EUROPEAN PATENT SPECIFICATION**

(45) Date of publication and mention
of the grant of the patent:
**26.07.2023 Bulletin 2023/30**

(21) Application number: **19766146.5**

(22) Date of filing: **27.08.2019**

(51) International Patent Classification (IPC):
**H01L 29/15** *(2006.01)* **H01L 21/02** *(2006.01)*
**H01L 29/78** *(2006.01)* **H01L 29/10** *(2006.01)*

(52) Cooperative Patent Classification (CPC):
**H01L 29/151; H01L 29/1054; H01L 29/152;**
**H01L 29/7833;** H01L 21/02507

(86) International application number:
**PCT/US2019/048277**

(87) International publication number:
**WO 2020/046890 (05.03.2020 Gazette 2020/10)**

(54) **METHOD FOR MAKING SUPERLATTICE STRUCTURES WITH REDUCED DEFECT DENSITIES**

VERFAHREN ZUR HERSTELLUNG VON ÜBERGITTERSTRUKTUREN MIT REDUZIERTER
FEHLERDICHTE

PROCÉDÉ DE FABRICATION DE STRUCTURES DE SUPER-RÉSEAU PRÉSENTANT DES
DENSITÉS DE DÉFAUTS RÉDUITES

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **30.08.2018 US 201816117178**
**30.08.2018 US 201816117202**

(43) Date of publication of application:
**07.07.2021 Bulletin 2021/27**

(73) Proprietor: **Atomera Incorporated**
**Los Gatos, CA 95032 (US)**

(72) Inventors:
 • **WEEKS, Keith Doran**
 **Chandler, Arizona 85224 (US)**

 • **CODY, Nyles Wynn**
 **Tempe, Arizona 85284 (US)**
 • **HYTHA, Marek**
 **Brookline, Massachusetts 02446 (US)**
 • **MEARS, Robert J.**
 **Wellesley, Massachusetts 02482 (US)**
 • **STEPHENSON, Robert John**
 **Duxford, Cambridgeshire CB22 4PS (GB)**

(74) Representative: **Roberts, David**
**Page White & Farrer Limited**
**Bedford House**
**21A John Street**
**London WC1N 2BF (GB)**

(56) References cited:
**US-A1- 2005 282 330 US-B1- 9 558 939**

## Description

## Technical Field

The present disclosure generally relates to semiconductor devices and, more particularly, to methods for making semiconductor device with enhanced semiconductor materials.

## Background

Structures and techniques have been proposed to enhance the performance of semiconductor devices, such as by enhancing the mobility of the charge carriers. For example, U.S. Patent Application No. 2003/0057416 to Currie et al. discloses strained material layers of silicon, silicon-germanium, and relaxed silicon and also including impurity-free zones that would otherwise cause performance degradation. The resulting biaxial strain in the upper silicon layer alters the carrier mobilities enabling higher speed and/or lower power devices. Published U.S. Patent Application No. 2003/0034529 to Fitzgerald et al. discloses a CMOS inverter also based upon similar strained silicon technology.

U.S. Patent No. 6,472,685 B2 to Takagi discloses a semiconductor device including a silicon and carbon layer sandwiched between silicon layers so that the conduction band and valence band of the second silicon layer receive a tensile strain. Electrons having a smaller effective mass, and which have been induced by an electric field applied to the gate electrode, are confined in the second silicon layer, thus, an n-channel MOSFET is asserted to have a higher mobility.

U.S. Patent No. 4,937,204 to Ishibashi et al. discloses a superlattice in which a plurality of layers, less than eight monolayers, and containing a fractional or binary or a binary compound semiconductor layer, are alternately and epitaxially grown. The direction of main current flow is perpendicular to the layers of the superlattice.

U.S. Patent No. 5,357,119 to Wang et al. discloses a Si-Ge short period superlattice with higher mobility achieved by reducing alloy scattering in the superlattice. Along these lines, U.S. Patent No. 5,683,934 to Candelaria discloses an enhanced mobility MOSFET including a channel layer comprising an alloy of silicon and a second material substitutionally present in the silicon lattice at a percentage that places the channel layer under tensile stress.

U.S. Patent No. 5,216,262 to Tsu discloses a quantum well structure comprising two barrier regions and a thin epitaxially grown semiconductor layer sandwiched between the barriers. Each barrier region consists of alternate layers of $SiO_2/Si$ with a thickness generally in a range of two to six monolayers. A much thicker section of silicon is sandwiched between the barriers.

An article entitled "Phenomena in silicon nanostructure devices" also to Tsu and published online September 6, 2000 by Applied Physics and Materials Science & Processing, pp. 391-402 discloses a semiconductor-atomic superlattice (SAS) of silicon and oxygen. The Si/O superlattice is disclosed as useful in a silicon quantum and light-emitting devices. In particular, a green electroluminescence diode structure was constructed and tested. Current flow in the diode structure is vertical, that is, perpendicular to the layers of the SAS. The disclosed SAS may include semiconductor layers separated by adsorbed species such as oxygen atoms, and CO molecules. The silicon growth beyond the adsorbed monolayer of oxygen is described as epitaxial with a fairly low defect density. One SAS structure included a 1.1 nm thick silicon portion that is about eight atomic layers of silicon, and another structure had twice this thickness of silicon. An article to Luo et al. entitled "Chemical Design of Direct-Gap Light-Emitting Silicon" published in Physical Review Letters, Vol. 89, No. 7 (August 12, 2002) further discusses the light emitting SAS structures of Tsu.

Published International Application WO 02/103,767 A1 to Wang, Tsu and Lofgren, discloses a barrier building block of thin silicon and oxygen, carbon, nitrogen, phosphorous, antimony, arsenic or hydrogen to thereby reduce current flowing vertically through the lattice more than four orders of magnitude. The insulating layer/barrier layer allows for low defect epitaxial silicon to be deposited next to the insulating layer.

Published Great Britain Patent Application 2,347,520 to Mears et al. discloses that principles of Aperiodic Photonic Band-Gap (APBG) structures may be adapted for electronic bandgap engineering. In particular, the application discloses that material parameters, for example, the location of band minima, effective mass, etc., can be tailored to yield new aperiodic materials with desirable band-structure characteristics. Other parameters, such as electrical conductivity, thermal conductivity and dielectric permittivity or magnetic permeability are disclosed as also possible to be designed into the material.

Furthermore, U.S. Pat. No. 6,376,337 to Wang et al. discloses a method for producing an insulating or barrier layer for semiconductor devices which includes depositing a layer of silicon and at least one additional element on the silicon substrate whereby the deposited layer is substantially free of defects such that epitaxial silicon substantially free of defects can be deposited on the deposited layer. Alternatively, a monolayer of one or more elements, preferably comprising oxygen, is absorbed on a silicon substrate. A plurality of insulating layers sandwiched between epitaxial silicon forms a barrier composite.

US 2005/282330 relates to a method for making a semiconductor device including forming a superlattice including a plurality of stacked groups of layers. Each group of the superlattice may include a plurality of stacked base semiconductor monolayers defining a base semiconductor portion and an energy band-modifying layer thereon. Moreover, the energy-band modifying layer may include at least one non-semiconductor monolayer constrained within a crystal lattice of adjacent base semiconductor portions. At least one group of layers of the superlattice may be substantially undoped.

Despite the existence of such approaches, further enhancements may be desirable for using advanced semiconductor processing techniques in certain applications.

## Summary

A method for making a semiconductor device according to the invention includes forming a superlattice on a substrate comprising a plurality of stacked groups of layers, with each group of layers including a plurality of stacked base semiconductor monolayers defining a base semiconductor portion and at least one non-semiconductor monolayer constrained within a crystal lattice of adjacent base semiconductor portions. Moreover, forming at least one of the base semiconductor portions includes overgrowing the at least one base semiconductor portion and etching back the overgrown at least one base semiconductor portion.

More particularly, forming each base semiconductor portion may further include forming a first set of the base semiconductor monolayers, performing a thermal anneal, and forming a second set of the base semiconductor monolayers on the first set after the thermal anneal. By way of example, the first set of the base semiconductor monolayers may have a thickness in a range of 6-10Å, and the second set of the base semiconductor monolayers may have a thickness in a range of 4-50Å.

In accordance with one example, etching back the overgrown at least one base semiconductor portion may comprise etching between 2 and 50Å of the at least one base semiconductor portion. Also by way of example, etching back the overgrown at least one base semiconductor portion may comprise etching the overgrown at least one base semiconductor portion at a temperature in a range of semiconductor cap layer by forming a first semiconductor cap portion on the plurality of groups of layers at a first temperature, and forming a second semiconductor cap portion on the first semiconductor cap portion at a second temperature higher than the first temperature. By way of example, the first semiconductor cap portion may have a thickness in a range of 4 to 100Å. Also by way of example, the base semiconductor monolayers may comprise silicon monolayers, and the non-semiconductor monolayers may comprise oxygen.

In accordance with another aspect, a semiconductor device may include a substrate and a superlattice on the substrate including a plurality of stacked groups of layers. Each group of layers may include a plurality of stacked base semiconductor monolayers defining a base semiconductor portion and at least one non-semiconductor monolayer constrained within a crystal lattice of adjacent base semiconductor portions. Furthermore, an upper portion of at least one of said base semiconductor portions adjacent the respective at least one non-semiconductor monolayer may have a defect density less than or equal to $1 \times 10^5/cm^2$.

By way of example, the superlattice may include at least four groups of layers. Furthermore, each base semiconductor portion may have a thickness in a range of 20-25Å. The superlattice may also include a semiconductor cap layer on the plurality of groups of layers, which may have a thickness in a range of 70 to 90 nm, for example. The semiconductor device may further include source and drain regions on the substrate on opposing ends of the superlattice, and a gate overlying the superlattice.

## Brief Description of the Drawings

FIG. 1 is a greatly enlarged schematic cross-sectional view of a superlattice for use in a semiconductor device in accordance with an example embodiment.

FIG. 2 is a perspective schematic atomic diagram of a portion of the superlattice shown in FIG. 1.

FIG. 3 is a greatly enlarged schematic cross-sectional view of another embodiment of a superlattice in accordance with an example embodiment.

FIG. 4A is a graph of the calculated band structure from the gamma point (G) for both bulk silicon as in the prior art, and for the 4/1 Si/O superlattice as shown in FIGS. 1-2.

FIG. 4B is a graph of the calculated band structure from the Z point for both bulk silicon as in the prior art, and for the 4/1 Si/O superlattice as shown in FIGS. 1-2.

FIG. 4C is a graph of the calculated band structure from both the gamma and Z points for both bulk silicon as in the prior art, and for the 5/1/3/1 Si/O superlattice as shown in FIG. 3.

FIG. 5 is a flow diagram illustrating a process for making a superlattice in accordance with an example embodiment with reduced defect density.

FIGS. 6-12 are a series of schematic cross-sectional diagrams illustrating corresponding steps to the method of FIG. 5.

FIG. 13 is a flow diagram illustrating another process for making a superlattice in accordance with an example embodiment with reduced defect density.

FIG. 14 is a schematic cross-sectional diagram of a semiconductor device incorporating a superlattice fabricated according to the method of FIG. 5 or FIG. 13.

## Detailed Description

Example embodiments will now be described more fully hereinafter with reference to the accompanying drawings, in which the example embodiments are shown. The embodiments may, however, be implemented in many different forms and should not be construed as limited to the specific examples set forth herein. Rather, these embodiments are provided so that this disclosure will be thorough and complete. Like numbers refer to like elements throughout, and prime notation is used to indicate similar elements in different embodiments.

Generally speaking, the present disclosure relates to a process for making an enhanced semiconductor superlattice or film, which is also referred to as an "MST" film or layer, or "MST technology", in this disclosure. More particularly, the MST technology relates to advanced semiconductor materials such as the superlattice **25** described further below. Applicant theorizes, without wishing to be bound thereto, that certain superlattices as described herein reduce the effective mass of charge carriers and that this thereby leads to higher charge carrier mobility. Effective mass is described with various definitions in the literature. As a measure of the improvement in effective mass Applicant's use a "conductivity reciprocal effective mass tensor", $\mathbf{M}_e^{-1}$ and $\mathbf{M}_h^{-1}$ for electrons and holes respectively, defined as:

$$\mathbf{M}_{e,ij}^{-1}(E_F,T) = \frac{\sum\limits_{E>E_F} \int\limits_{B.Z.} \left(\nabla_{\mathbf{k}}E(\mathbf{k},n)\right)_i \left(\nabla_{\mathbf{k}}E(\mathbf{k},n)\right)_j \frac{\partial f(E(\mathbf{k},n),E_F,T)}{\partial E} d^3\mathbf{k}}{\sum\limits_{E>E_F} \int\limits_{B.Z.} f(E(\mathbf{k},n),E_F,T) d^3\mathbf{k}}$$

for electrons and:

$$\mathbf{M}_{h,ij}^{-1}(E_F,T) = \frac{-\sum\limits_{E<E_F} \int\limits_{B.Z.} \left(\nabla_{\mathbf{k}}E(\mathbf{k},n)\right)_i \left(\nabla_{\mathbf{k}}E(\mathbf{k},n)\right)_j \frac{\partial f(E(\mathbf{k},n),E_F,T)}{\partial E} d^3\mathbf{k}}{\sum\limits_{E<E_F} \int\limits_{B.Z.} (1-f(E(\mathbf{k},n),E_F,T)) d^3\mathbf{k}}$$

for holes, where f is the Fermi-Dirac distribution, $E_F$ is the Fermi energy, T is the temperature, $E(\mathbf{k},n)$ is the energy of an electron in the state corresponding to wave vector $\mathbf{k}$ and the $n^{th}$ energy band, the indices i and j refer to Cartesian coordinates x, y and z, the integrals are taken over the Brillouin zone (B.Z.), and the summations are taken over bands with energies above and below the Fermi energy for electrons and holes respectively.

Applicant's definition of the conductivity reciprocal effective mass tensor is such that a tensorial component of the conductivity of the material is greater for greater values of the corresponding component of the conductivity reciprocal effective mass tensor. Again Applicant theorizes without wishing to be bound thereto that the superlattices described herein set the values of the conductivity reciprocal effective mass tensor so as to enhance the conductive properties of the material, such as typically for a preferred direction of charge carrier transport. The inverse of the appropriate tensor element is referred to as the conductivity effective mass. In other words, to characterize semiconductor material structures, the conductivity effective mass for electrons/holes as described above and calculated in the direction of intended carrier transport is used to distinguish improved materials.

Applicant has identified improved materials or structures for use in semiconductor devices. More specifically, Applicant has identified materials or structures having energy band structures for which the appropriate conductivity effective masses for electrons and/or holes are substantially less than the corresponding values for silicon. In addition to the enhanced mobility characteristics of these structures, they may also be formed or used in such a manner that they provide piezoelectric, pyroelectric, and/or ferroelectric properties that are advantageous for use in a variety of different types of devices, as will be discussed further below.

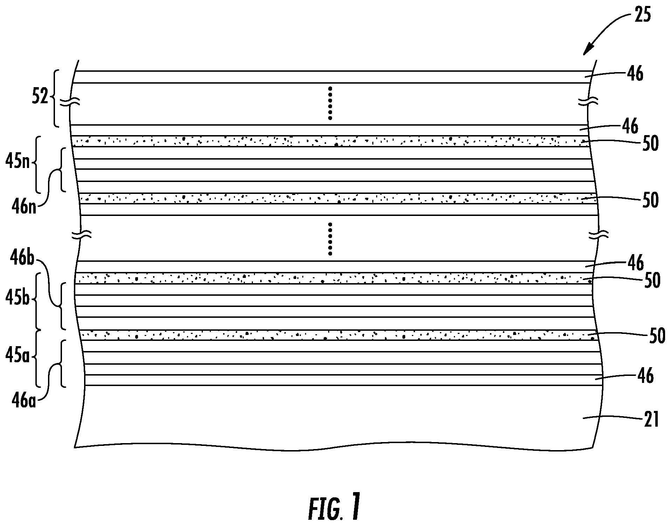

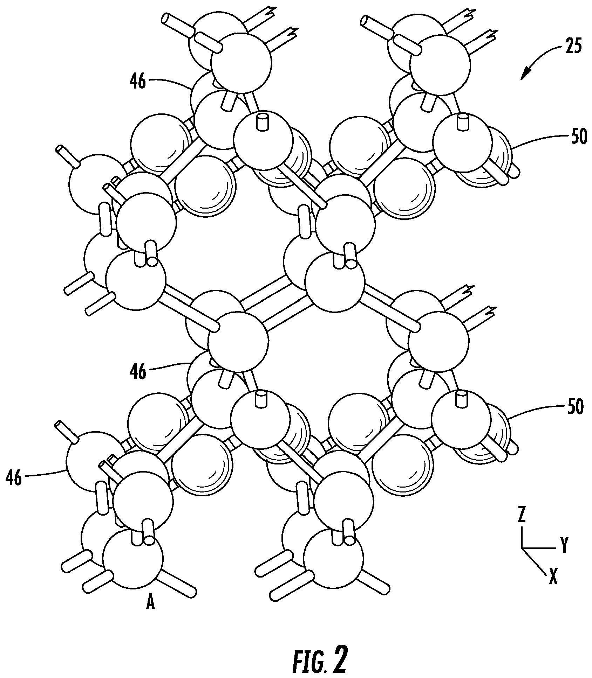

Referring now to FIGS. 1 and 2, the materials or structures are in the form of a superlattice **25** whose structure is controlled at the atomic or molecular level and may be formed using known techniques of atomic or molecular layer deposition. The superlattice **25** includes a plurality of layer groups **45a-45n** arranged in stacked relation, as perhaps best understood with specific reference to the schematic cross-sectional view of FIG. 1.

Each group of layers **45a-45n** of the superlattice **25** illustratively includes a plurality of stacked base semiconductor monolayers **46** defining a respective base semiconductor portion **46a-46n** and an energy band-modifying layer **50** thereon. The energy band-modifying layers **50** are indicated by stippling in FIG. 1 for clarity of illustration.

The energy band-modifying layer **50** illustratively includes one non-semiconductor monolayer constrained within a crystal lattice of adjacent base semiconductor portions. By "constrained within a crystal lattice of adjacent base semiconductor portions" it is meant that at least some semiconductor atoms from opposing base semiconductor portions **46a-46n** are chemically bound together through the non-semiconductor monolayer **50** therebetween, as seen in FIG. 2. Generally speaking, this configuration is made possible by controlling the amount of non-semiconductor material that is deposited on semiconductor portions **46a-46n** through atomic layer deposition techniques so that not all (i.e., less than full or 100% coverage) of the available semiconductor bonding sites are populated with bonds to non-semiconductor atoms, as will be discussed further below. Thus, as further monolayers **46** of semiconductor material are deposited on or over a non-semiconductor monolayer **50,** the newly deposited semiconductor atoms will populate the remaining vacant bonding sites of the semiconductor atoms below the non-semiconductor monolayer.

In other embodiments, more than one such non-semiconductor monolayer may be possible. It should be noted that reference herein to a non-semiconductor or semiconductor monolayer means that the material used for the monolayer would be a non-semiconductor or semiconductor if formed in bulk. That is, a single monolayer of a material, such as silicon, may not necessarily exhibit the same properties that it would if formed in bulk or in a relatively thick layer, as will be appreciated by those skilled in the art.

Applicant theorizes without wishing to be bound thereto that energy band-modifying layers **50** and adjacent base semiconductor portions **46a-46n** cause the superlattice **25** to have a lower appropriate conductivity effective mass for the charge carriers in the parallel layer direction than would otherwise be present. Considered another way, this parallel direction is orthogonal to the stacking direction. The band modifying layers **50** may also cause the superlattice **25** to have a common energy band structure, while also advantageously functioning as an insulator between layers or regions vertically above and below the superlattice.

Moreover, this superlattice structure may also advantageously act as a barrier to dopant and/or material diffusion between layers vertically above and below the superlattice **25.** These properties may thus advantageously allow the superlattice **25** to provide an interface for high-K dielectrics which not only reduces diffusion of the high-K material into the channel region, but which may also advantageously reduce unwanted scattering effects and improve device mobility, as will be appreciated by those skilled in the art.

It is also theorized that semiconductor devices including the superlattice **25** may enjoy a higher charge carrier mobility based upon the lower conductivity effective mass than would otherwise be present. In some embodiments, and as a result of the band engineering achieved by the present invention, the superlattice **25** may further have a substantially direct energy bandgap that may be particularly advantageous for opto-electronic devices, for example.

The superlattice **25** also illustratively includes a cap layer **52** on an upper layer group **45n.** The cap layer **52** may comprise a plurality of base semiconductor monolayers **46.** The cap layer **52** may range from 2 monolayers to 25Å or more (e.g., 100Å) of the base semiconductor, and, more preferably between 10 to 50 monolayers.

Each base semiconductor portion **46a-46n** may comprise a base semiconductor selected from the group consisting of Group IV semiconductors, Group III-V semiconductors, and Group II-VI semiconductors. Of course, the term Group IV semiconductors also includes Group IV-IV semiconductors, as will be appreciated by those skilled in the art. More particularly, the base semiconductor may comprise at least one of silicon and germanium, for example.

Each energy band-modifying layer **50** may comprise a non-semiconductor selected from the group consisting of oxygen, nitrogen, fluorine, carbon and carbon-oxygen, for example. The non-semiconductor is also desirably thermally stable through deposition of a next layer to thereby facilitate manufacturing. In other embodiments, the non-semiconductor may be another inorganic or organic element or compound that is compatible with the given semiconductor processing as will be appreciated by those skilled in the art. More particularly, the base semiconductor may comprise at least one of silicon and germanium, for example.

It should be noted that the term monolayer is meant to include a single atomic layer and also a single molecular layer. It is also noted that the energy band-modifying layer **50** provided by a single monolayer is also meant to include a monolayer wherein not all of the possible sites are occupied (i.e., there is less than full or 100% coverage). For example, with particular reference to the atomic diagram of FIG. 2, a 4/1 repeating structure is illustrated for silicon as the base semiconductor material, and oxygen as the energy band-modifying material. Only half of the possible sites for oxygen are occupied in the illustrated example.

In other embodiments and/or with different materials this one-half occupation would not necessarily be the case as will be appreciated by those skilled in the art. Indeed it can be seen even in this schematic diagram, that individual atoms of oxygen in a given monolayer are not precisely aligned along a flat plane as will also be appreciated by those of skill in the art of atomic deposition. By way of example, a preferred occupation range is from about one-eighth to one-half of the possible oxygen sites being full, although other numbers may be used in certain embodiments.

Silicon and oxygen are currently widely used in conventional semiconductor processing, and, hence, manufacturers will be readily able to use these materials as described herein. Atomic or monolayer deposition is also now widely used. Accordingly, semiconductor devices incorporating the superlattice **25** in accordance with the invention may be readily adopted and implemented, as will be appreciated by those skilled in the art.

In one example implementation of the Si/O superlattice, for example, the number of silicon monolayers may be seven or less so that the energy band of the superlattice is common or relatively uniform throughout to achieve the desired advantages. However, in other embodiments a different spacing may be used, e.g., up to 5nm or more. The 4/1 repeating structure shown in FIGS. 1 and 2, for Si/O has been modeled to indicate an enhanced mobility for electrons and holes in the X direction. For example, the calculated conductivity effective mass for electrons (isotropic for bulk silicon) is 0.26 and for the 4/1 SiO superlattice in the X direction it is 0.12 resulting in a ratio of 0.46. Similarly, the calculation for holes yields values of 0.36 for bulk silicon and 0.16 for the 4/1 Si/O superlattice resulting in a ratio of 0.44.

While such a directionally preferential feature may be desired in certain semiconductor devices, other devices may benefit from a more uniform increase in mobility in any direction parallel to the groups of layers. It may also be beneficial to have an increased mobility for both electrons and holes, or just one of these types of charge carriers as will be appreciated by those skilled in the art.

The lower conductivity effective mass for the 4/1 Si/O embodiment of the superlattice **25** may be less than two-thirds the conductivity effective mass than would otherwise occur, and this applies for both electrons and holes. Of course, the superlattice **25** may further comprise at least one type of conductivity dopant therein, as will also be appreciated by those skilled in the art.

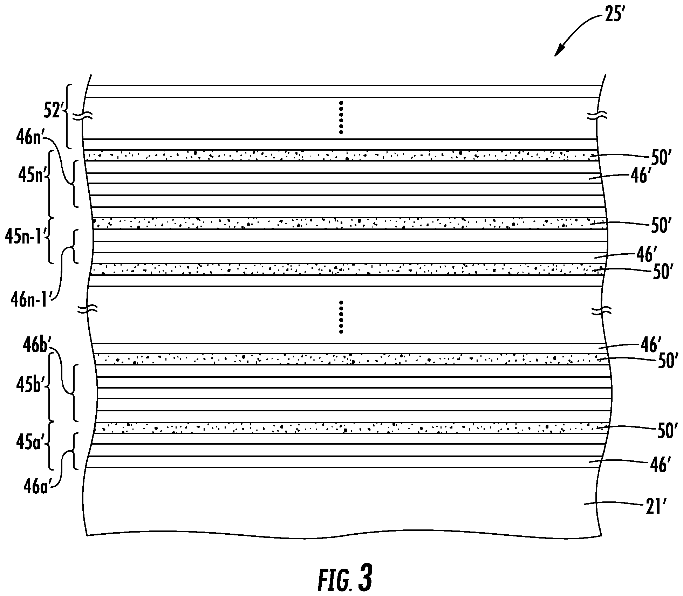

Indeed, referring now additionally to FIG. 3, another embodiment of a superlattice **25'** in accordance with the invention having different properties is now described. In this embodiment, a repeating pattern of 3/1/5/1 is illustrated. More particularly, the lowest base semiconductor portion **46a'** has three monolayers, and the second lowest base semiconductor portion **46b'** has five monolayers. This pattern repeats throughout the superlattice **25'**. The energy band-modifying layers **50'** may each include a single monolayer. For such a superlattice **25'** including Si/O, the enhancement of charge carrier mobility is independent of orientation in the plane of the layers. Those other elements of FIG. 3 not specifically mentioned are similar to those discussed above with reference to FIG. 1 and need no further discussion herein.

In some device embodiments, all of the base semiconductor portions of a superlattice may be a same number of monolayers thick. In other embodiments, at least some of the base semiconductor portions may be a different number of monolayers thick. In still other embodiments, all of the base semiconductor portions may be a different number of monolayers thick.

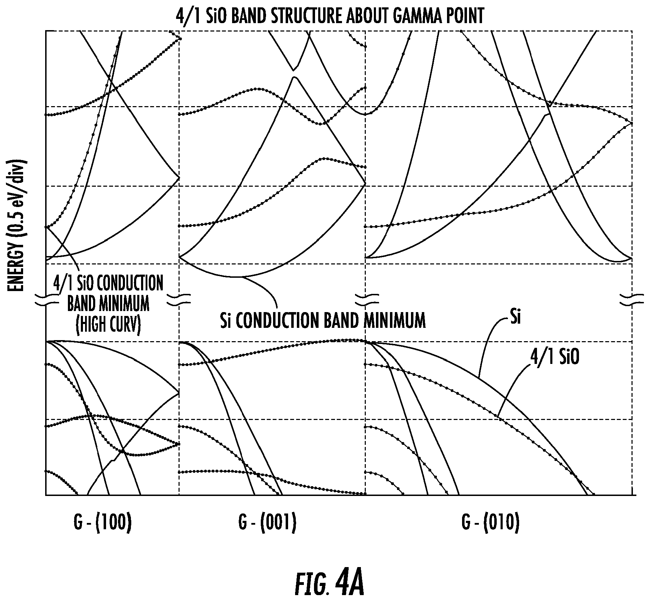

In FIGS. 4A-4C, band structures calculated using Density Functional Theory (DFT) are presented. It is well known in the art that DFT underestimates the absolute value of the bandgap. Hence all bands above the gap may be shifted by an appropriate "scissors correction." However the shape of the band is known to be much more reliable. The vertical energy axes should be interpreted in this light.

FIG. 4A shows the calculated band structure from the gamma point (G) for both bulk silicon (represented by continuous lines) and for the 4/1 Si/O superlattice **25** shown in FIG. 1 (represented by dotted lines). The directions refer to the unit cell of the 4/1 Si/O structure and not to the conventional unit cell of Si, although the (001) direction in the figure does correspond to the (001) direction of the conventional unit cell of Si, and, hence, shows the expected location of the Si conduction band minimum. The (100) and (010) directions in the figure correspond to the (110) and (-110) directions of the conventional Si unit cell. Those skilled in the art will appreciate that the bands of Si on the figure are folded to represent them on the appropriate reciprocal lattice directions for the 4/1 Si/O structure.

It can be seen that the conduction band minimum for the 4/1 Si/O structure is located at the gamma point in contrast to bulk silicon (Si), whereas the valence band minimum occurs at the edge of the Brillouin zone in the (001) direction which we refer to as the Z point. One may also note the greater curvature of the conduction band minimum for the 4/1 Si/O structure compared to the curvature of the conduction band minimum for Si owing to the band splitting due to the perturbation introduced by the additional oxygen layer.

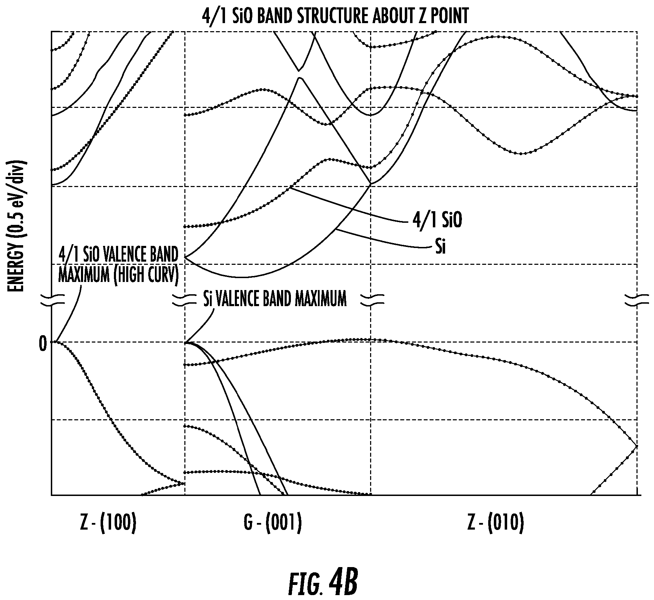

FIG. 4B shows the calculated band structure from the Z point for both bulk silicon (continuous lines) and for the 4/1 Si/O superlattice **25** (dotted lines). This figure illustrates the enhanced curvature of the valence band in the (100) direction.

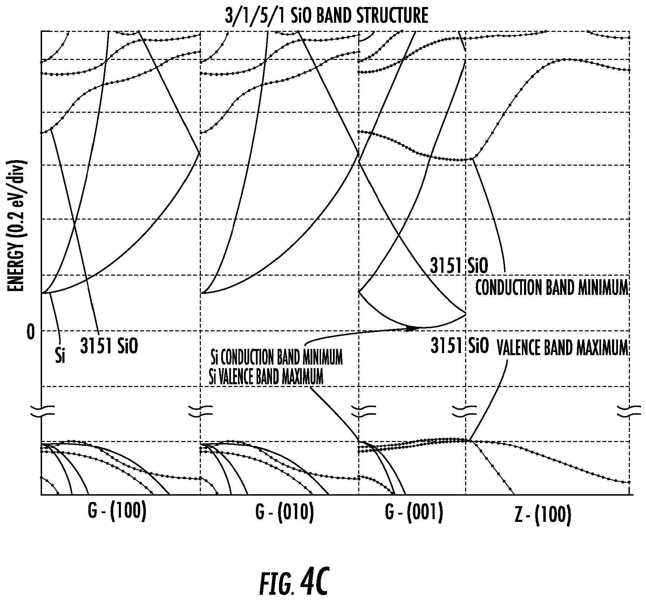

FIG. 4C shows the calculated band structure from both the gamma and Z point for both bulk silicon (continuous lines) and for the 5/1/3/1 Si/O structure of the superlattice **25'** of FIG. 3 (dotted lines). Due to the symmetry of the 5/1/3/1 Si/O structure, the calculated band structures in the (100) and (010) directions are equivalent. Thus the conductivity effective mass and mobility are expected to be isotropic in the plane parallel to the layers, i.e. perpendicular to the (001) stacking direction. Note that in the 5/1/3/1 Si/O example the conduction band minimum and the valence band maximum are both at or close to the Z point.

Although increased curvature is an indication of reduced effective mass, the appropriate comparison and discrimination may be made via the conductivity reciprocal effective mass tensor calculation. This leads Applicant to further theorize that the 5/1/3/1 superlattice **25'** should be substantially direct bandgap. As will be understood by those skilled in the art, the appropriate matrix element for optical transition is another indicator of the distinction between direct and indirect bandgap behavior.

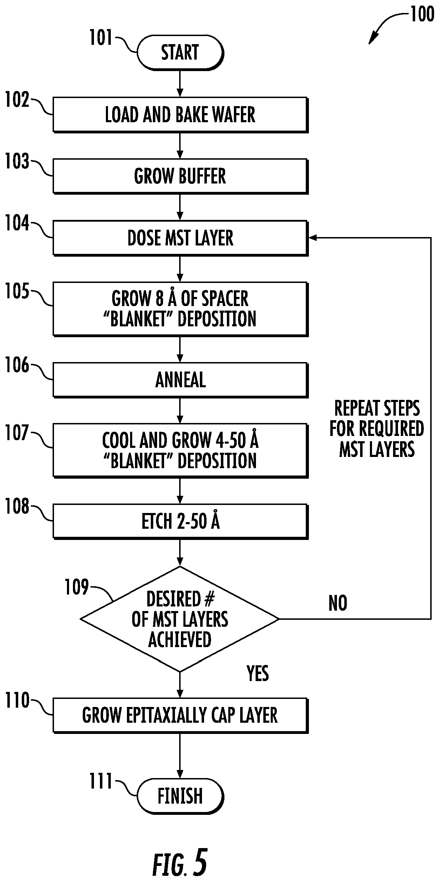

Having described example MST film structures, an approach for depositing MST films **25** which provides for reduced defect densities is now described with reference to the flow diagram **100** of FIG. 5 and FIGS. 6-11. In particular, an approach is provided for making the above-described MST films **25** using a cyclic deposition and etch (CDE) process for growing the base semiconductor portions **46a-46n** of the superlattice stack to advantageously reduce the amount of physical defects that are formed in the MST superlattice film. In an example implementation, the level of defects may be reduced by at least one to two orders of magnitude for a given amount of oxygen that is incorporated in the MST film stack. While the above-described approaches provide for MST films with relatively low defect levels plus significant mobility improvement and leakage reduction in semiconductor devices, the present approach advantageously provides for even further reduction in defect levels in MST film stacks for applications that may be particularly sensitive to such defects.

Generally speaking, the present approach uses a CDE process to form the base semiconductor portions **46a-46n,** which are also referred to as "spacer layers" herein, using a single CDE cycle (meaning one cycle contains non-semiconductor (e.g., oxygen) dosing, spacer and etch back). The use of this etch back reduces the defects in the spacer layer by removing the initial start of the defects. The etching process more aggressively etches defective silicon faster than non-defective silicon. Etchant gas can only etch from the surface downward for non-defective regions of epitaxial growth, but the etch can attack in multiple directions where a defect is present.

Beginning at Block **101,** the method illustratively includes a wafer or substrate **21** preparation step, which in this example is a load and bake (Block **102**). Baking as an epitaxial growth surface pre-treatment is commonly used, although other approaches may be used to prepare the substrate **21** for epitaxial growth. More particularly, single crystal silicon surfaces typically require some type of surface preparation prior to epitaxial growth, such as a hydrogen bake. Another alternative would be a hydrofluoric acid (HF) wet clean with an $H_2O$ rinse, followed by a load and low temperature bake in a reduced pressure chemical vapor deposition reactor. Another approach may utilize a lower temperature chemical treatment similar to the AMAT Siconi or the ASM Previum processes, for example. One skilled in the art of epitaxial growth will understand that other suitable surface pre-treatment approaches may also be used, and the foregoing examples are not intended to be an exhaustive list of pre-treatment methods.

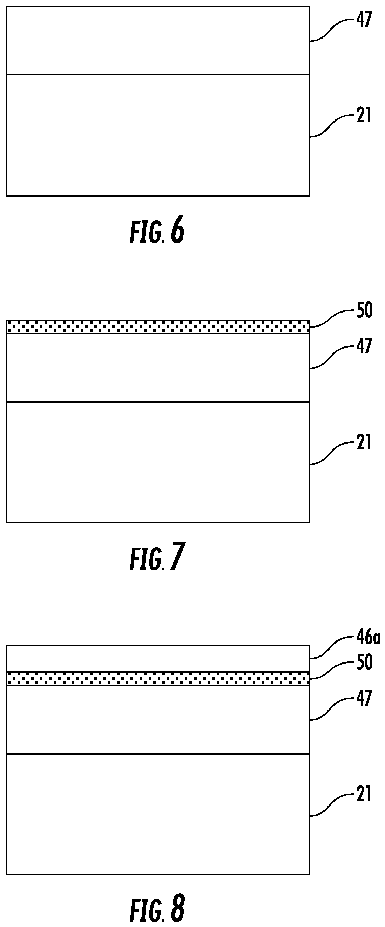

With the appropriate pre-treatment, an in-situ semiconductor (e.g., epitaxial silicon) buffer layer **47** may then be formed on the substrate **21**, at Block **103** (FIG. 6). An oxygen monolayer(s) **50** may then be formed on the buffer layer **47**, at Block **104** (FIG. 7). One exemplary approach to forming non-semiconductor monolayers using $N_2O$ as an oxygen source is set forth in U.S. Pat. No. 9,558,939 to Stephenson et al. However, it should be noted that other approaches and oxygen (or other non-semiconductor) delivery agents may also be used in different embodiments.

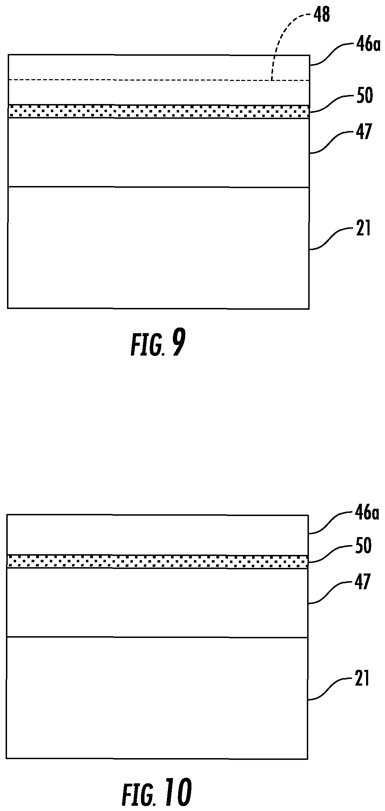

In the illustrated example, the first base silicon portion **46a** is then formed by a blanket epitaxial silicon deposition of a first set of base silicon monolayers having a thickness in a range of 6-10Å, and more particularly around 8Å, at Block **105** (FIG. 8). Then, an intermediate anneal is performed (Block **106**), followed by a blanket epitaxial growth of a second set of base silicon monolayers with a thickness in a range of 4-50Å, at Block **107** (FIG. 9). The dashed line **48** in FIG. 9 shows the height of the first set of base silicon monolayers. More particularly, the second growth is an overgrowth that is thicker than the final desired thickness of the base silicon portion **46a.** The overgrowth may then be etched back (Block **108,** FIG. 10) to the final desired thickness of the base silicon portion **46a.** By way of example, the amount of silicon that is etched back may be in a range of 2-50Å in a typical implementation, for example.

The overgrowth and etch back operation may be implemented over a relatively wide range of temperatures and pressures. By way of example, the etch temperature range may be between 300°C and 1200°C. More particularly, this temperature may be in a range between 400°C and 800°C, and more specifically between 500°C and 750°C for typical implementations. An example pressure range may be between 1 Torr and 760 Torr for chemical vapor deposition processes, and more particularly between 10 Torr and 600 Torr. Generally speaking, lower pressure may be used in the low-pressure regime (P<1 Torr) and the Ultra High Vacuum regime (P<$10^{-7}$Torr). Etch back temperature and pressure may be isobaric and isothermal with the growth process, for example, to help provide higher process throughput.

While the CDE approach may be used over the entire pressure range noted above, high-pressure implementation in the reduced pressure process space may be desirable since at these pressures the adatom diffusion length is shorter than at LP and UHV. In the LP and UHV deposition, atoms are prone to diffusion toward step corners away from the deposition regions. As a result, reduced pressure deposited and etched superlattice deposition may have smoother surfaces than LP and UHV processed wafers, for example.

Example etchant gases may include $Cl_2$ and HCl. HCl and $Cl_2$ work well for superlattice structures deposited on patterned/structured wafers, as these etchants etch little or no oxides and/or nitrides of silicon in the temperature and pressure range used for atmospheric and reduced pressure chemical vapor deposition processes, for example. Other suitable etchants such as $NF_3$ may also be used, for example. A liquid etchant such as TMAH ($C_4H_{13}NO$) may be used to etch at room temperature by cyclically removing and reintroducing the wafers to the growth reactor.

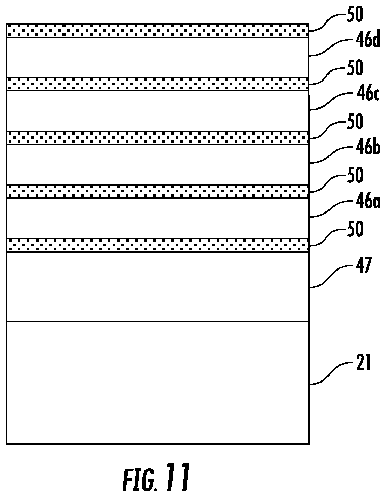

The steps illustrated above with respect to Blocks **104-108** may then be repeated to create the desired number of groups of layers of the superlattice **25,** at Block **109.** In the example illustrated in FIG. 11, there are four groups of layers, but in other embodiments more or less groups may be used. Moreover, as noted above, each of the base silicon portions **46a-46d** may have a same number of silicon monolayers, alternating numbers of silicon monolayers, or have different numbers of silicon monolayers in different embodiments.

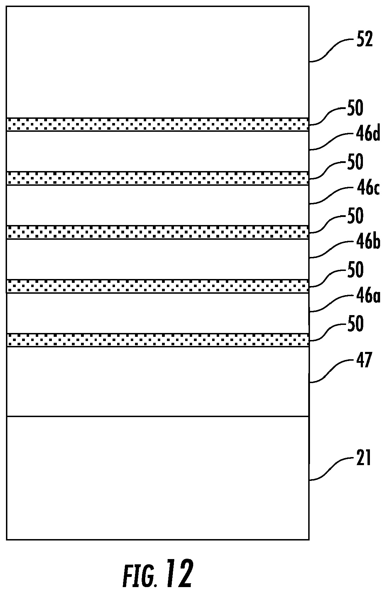

Once all of the base silicon portions **46a-46d** and oxygen monolayers **50** are formed, another epitaxial silicon layer **52** may be grown (FIG. 12) to create the final cap layer for the superlattice **25** (Block **110**). By way of example, selective epitaxial growth may be used for capping the MST film for typical applications, but in some instances non-selective, pseudo-selective, or any combination of the three growth methods may be used. Pseudo-selective growth involves a cyclic approach, i.e., one deposit and one etch. The method of FIG. 5 illustratively concludes at Block **111,** although further processing steps may be performed to create different types of semiconductor devices incorporating the superlattice **25,** as will be discussed further below.

The above-described process may be considered a pseudo-selective epitaxial growth, in which the amorphous and/or polysilicon etch rate is selected to be faster than the epitaxial etch rate. In other words, the poly and/or amorphous to epitaxial etch rate ratio is selected to be greater than one. If this were not the case, then the entire superlattice spacer would be lost during etching before the unwanted non-selective deposits were removed from the wafer non-single crystal structures. More particularly, the etch ratio may be adjusted based upon how aggressive of a defect reduction is desired in superlattices **25** for the given application. By way of example, the ratio of polysilicon and/or amorphous silicon to epitaxial etch selectivity may be greater than 1.5, and more particularly in a range of 1.5 to 10. However, higher selectivity ratios may also be used in some embodiments.

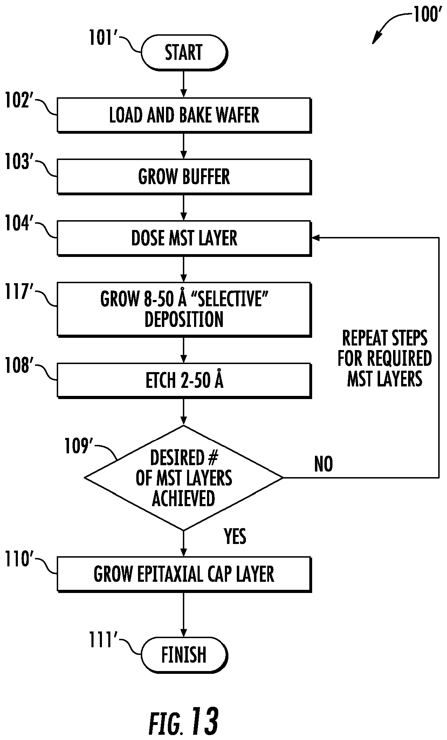

Turning now to the flow diagram **100'** of FIG. 13, another example approach is provided that is already selective without an etch back. Here, the initial blanket growth and anneal steps shown in FIG. 5 at Blocks **105-106** are omitted, and instead a cooling and selective epitaxial growth (e.g., 8 to 50Å) is performed (Block **117'**) to define the base silicon portions **46a-46d** of the superlattice **25.** The subsequent etch back may be in a range of 2 to 50Å, for example. In this case, one may choose an etch rate that is relatively high yet still controllable at the given pressure and temperature of the spacer growth such that defects are removed at the highest rate to minimize the impact to process throughput.

Both the pseudo selective process **100** and the selective process **100'** have improved defectivity with the etch back. The amount of etch back may be tuned by increasing the amount of initial epitaxy grown, so there is a relatively wide window of possibilities for improved detectivity. The particular process values may be selected using the ranges provided above so that the amount of deposition and etch advantageously creates the desired spacer thickness and defect level for the final MST film **25.** Here again, the number of groups of layers and thicknesses used for the spacers will vary based upon the desired application of the MST film **25,** as will be appreciated by those skilled in the art.

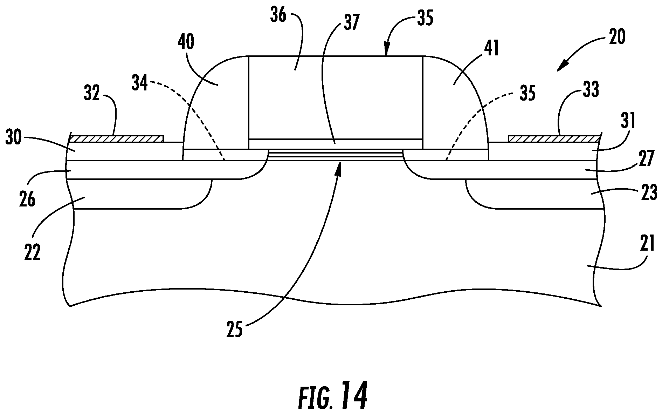

As noted above, after the process steps shown in FIG. 5 or 13 are complete, additional processing steps may be performed to create various devices, such as a planar MOSFET **20** now described with reference to FIG. 14. One skilled in the art, however, will appreciate that the materials and techniques identified herein may be used in many different types of semiconductor devices, such as discrete devices and/or integrated circuits. The illustrated MOSFET **20** includes the substrate **21,** source/drain regions **22, 23,** source/drain extensions **26, 27,** and a channel region therebetween provided by the superlattice **25.** Source/drain silicide layers **30, 31** and source/drain contacts **32, 33** overlie the source/drain regions as will be appreciated by those skilled in the art. Regions indicated by dashed lines **34, 35** are optional vestigial portions formed originally with the superlattice **25,** but thereafter heavily doped. In other embodiments, these vestigial superlattice regions **34, 35** may not be present as will also be appreciated by those skilled in the art. A gate **35** illustratively includes a gate insulating layer **37** adjacent the channel provided by the superlattice **25,** and a gate electrode layer **36** on the gate insulating layer. Sidewall spacers **40, 41** are also provided in the illustrated MOSFET **20.** Using the above-described fabrication techniques, defect densities of $\leq 1 \times 10^5/cm^2$ may be achieved in one or more of the base semiconductor portions **46a-46n** of the superlattice **25** adjacent the non-semiconductor monolayer **50** interface.

It should also be noted that in some embodiments of the methods shown in FIGS. 5 and 13, additional epitaxial growth may optionally be performed after defect elimination (i.e., following the steps illustrated at Blocks **108, 108'**). As noted above, the approaches discussed herein are advantageously used to help optimize the initial deposition to etch ratio to annihilate crystalline defects. Additional epitaxial growth may be desirable in some circumstances because for a given set of process conditions, the optimum final spacer thickness for device performance may be so thick that that it is beyond the optimal deposit to etch ratio. Thus, an additional amount of silicon spacer growth may be used, after defect elimination, to meet the device spacer thickness target. After the steps illustrated at Blocks **108, 108'** are complete, the defects have already been removed and any additional epitaxial growth may be grown defect free, as will be appreciated by those skilled in the art.

By way of example, in an application with a desired 40Å spacer between the inserted oxygen monolayers, epitaxially growing 60Å and etching back 20Å of the silicon may not be enough etch to get to the root of the defects, and for throughput considerations this may result in an undesirable amount of excess growth and etching. It may be more efficient to grow 16Å total silicon and etch back 8Å, leaving an 8Å epitaxial spacer seed. Then, the remaining 32Å may be grown in the present example.

Another potential advantage of this approach is film morphology. If a relatively thick spacer layer is grown and etched sufficiently to remove all defects in their entirety, this may lead to etch pits in the region where the defect once existed. The nature of the growth process is such that it along with surface migration will smooth these pits out if the indentations are shallow and small enough in diameter. There are some depths and diameters at which even enhanced growth kinetics and surface migration in and round the pit is not enough to allow for the pit to be leveled/smoothed/filled prior to finishing the superlattice growth.

Generally speaking, putting down oxygen at a higher rate will result in more defects, but also a higher oxidation throughput. One example of this would be oxidation at a higher than optimal dosing temperature, which may be near a higher silicon spacer growth temperature for throughput considerations. At a higher temperature some oxygen may bond with silicon in such a way that defects form in the silicon spacer deposit. However, the above-described approaches advantageously allow for some tradeoffs to be made in terms of process temperature, pressure, or carrier gas environment, which may not be optimal for oxidation, but still achieve a final low defect density epitaxial superlattice in addition to a high throughput process. The approach of targeting higher throughput may to the initial silicon layer being less than the device target spacer thickness. However, this may be acceptable because one may grow additional defect free silicon on top of the now defect free silicon spacer seed as described above to achieve the target spacer thickness.

Another example would be that defects are initiated as a result of the silicon growth process. Silicon grown at very low temperature (matching an improved oxidation temperature, for example) may have silicon adatoms that deposit and do not have time to move to proper lattice sites. This type of silicon growth situation may be generated by depositing the epitaxial layer in the 400 to 600°C temperature range at high growth rates, for example. Silicon atoms that sit in interstitial sites can cause a dislocation to form and propagate throughout the subsequent epitaxial stack, for example. Again, the etch back will polish/remove the defects at an optimal deposition to etch ratio based on the process conditions chosen. Additional silicon may then be added after the etch to help insure that the final spacer thickness adheres to the desired device targets. The additional silicon may be grown in accordance with process conditions that result in defect free growth, as will be appreciated by those skilled in the art.

Many modifications and other embodiments will come to the mind of one skilled in the art having the benefit of the teachings presented herein. Therefore, it is understood that the disclosure is not to be limited to the specific exemplary embodiments disclosed herein.

## Claims

1. A method for making a semiconductor device (20) comprising forming a superlattice (25) on a substrate (21) comprising a plurality of stacked groups of layers (45a-45n), with each group of layers comprising a plurality of stacked base semiconductor monolayers (46) defining a base semiconductor portion (46a-46n), and at least one non-semiconductor monolayer (50) constrained within a crystal lattice of adjacent base semiconductor portions, **characterized in that** forming at least one of the base semiconductor portions comprises:
   overgrowing the at least one base semiconductor portion and etching back the overgrown at least one base semiconductor portion.

2. The method of Claim 1 wherein forming each base semiconductor portion further comprises:

   forming a first set of the base semiconductor monolayers (105);
   performing a thermal anneal (106); and
   forming a second set of the base semiconductor monolayers on the first set after the thermal anneal (107).

3. The method of Claim 2 wherein the first set of the base semiconductor monolayers has a thickness in a range of 6-10Å.

4. The method of Claim 2 wherein the second set of the base semiconductor monolayers has a thickness in a range of 4-50Å.

5. The method of Claim 1 wherein etching back the overgrown at least one base semiconductor portion comprises etching between 2 and 50Å of the at least one base semiconductor portion.

6. The method of Claim 1 wherein etching back the overgrown at least one base semiconductor portion comprises etching the overgrown at least one base semiconductor portion at a temperature in a range of 500 to 750°C.

7. The method of Claim 1 further comprising forming a semiconductor cap layer (52) on the superlattice by forming a first semiconductor cap portion on the substrate at a first temperature, and forming a second semiconductor cap portion on the first semiconductor cap portion at a second temperature greater than or equal to the first temperature.

8. The method of Claim 7 wherein the first semiconductor cap portion has a thickness in a range of 4 to 100Å.

9. The method of Claim 1 wherein the base semiconductor monolayers comprise silicon monolayers.

10. The method of Claim 1 wherein the non-semiconductor monolayers comprise oxygen.

11. The method of claim 1 wherein an upper portion of said at least one of the base semiconductor portions adjacent the respective at least one non-semiconductor monolayer has a defect density less than or equal to $1 \times 10^5/cm^2$.

12. The method of claim 1 wherein the superlattice comprises at least four groups of layers.

13. The method of claim 1 wherein each base semiconductor portion has a thickness in a range of 20-25Å.

14. The method of claim 7 wherein the semiconductor cap layer has a thickness in a range of 70 to 90 nm.

15. The method of claim 1 further comprising forming source and drain regions on the substrate on opposing ends of the superlattice, and forming a gate overlying the superlattice.


**Patentansprüche**

1. Verfahren zur Herstellung eines Halbleiterbauelements (20), aufweisend Bilden eines Übergitters (25) auf einem Substrat (21) aufweisend mehrere gestapelte Schichtgruppen (45a-45n), wobei jede Schichtgruppe mehrere gestapelte Basishalbleitermonoschichten (46) aufweist, die einen Basishalbleiterabschnitt (46a-46n) definieren, und wenigstens eine Nicht-Halbleiter-Monoschicht (50), die in einem Kristallgitter von benachbarten Basishalbleiterabschnitten eingeschränkt ist, **dadurch gekennzeichnet, dass** das Bilden wenigstens eines der Basishalbleiterabschnitte aufweist:
Überwachsen des wenigstens einen Basishalbleiterabschnitts und Rückätzen des überwachsenen wenigstens einen Basishalbleiterabschnitts.

2. Verfahren nach Anspruch 1, wobei das Bilden jedes Basishalbleiterabschnitts ferner aufweist:

   Bilden eines ersten Satzes der Basishalbleitermonoschichten (105);
   Durchführen eines thermischen Glühens (106); und
   Bilden eines zweiten Satzes der Basishalbleitermonoschichten auf dem ersten Satz nach dem thermischen Glühen (107).

3. Verfahren nach Anspruch 2, wobei der erste Satz der Basishalbleitermonoschichten eine Dicke in einem Bereich von 6-10 Å hat.

4. Verfahren nach Anspruch 2, wobei der zweite Satz der Basishalbleitermonoschichten eine Dicke in einem Bereich von 4-50 Å hat.

5. Verfahren nach Anspruch 1, wobei das Rückätzen des überwachsenen wenigstens einen Basishalbleiterabschnitts ein Ätzen zwischen 2 und 50 Ä des wenigstens einen Basishalbleiterabschnitts aufweist.

6. Verfahren nach Anspruch 1, wobei das Rückätzen des überwachsenen wenigstens einen Basishalbleiterabschnitts ein Ätzen des überwachsenen wenigstens einen Basishalbleiterabschnitts bei einer Temperatur in einem Bereich von 500 bis 750°C aufweist.

7. Verfahren nach Anspruch 1, ferner aufweisend ein Bilden einer Halbleiterdeckschicht (52) auf dem Übergitter durch Bilden eines ersten Halbleiterdeckteils auf dem Substrat bei einer ersten Temperatur und Bilden eines zweiten Halbleiterdeckteils auf dem ersten Halbleiterdeckteil bei einer zweiten Temperatur, die größer oder gleich der ersten Temperatur ist.

8. Verfahren nach Anspruch 7, wobei der erste Halbleiterdeckabschnitt eine Dicke in einem Bereich von 4 bis 100 Å hat.

9. Verfahren nach Anspruch 1, wobei die Basishalbleitermonoschichten Silizium-Monoschichten aufweisen.

10. Verfahren nach Anspruch 1, wobei die Nicht-Halbleiter-Monoschichten Sauerstoff aufweisen.

11. Verfahren nach Anspruch 1, wobei ein oberer Abschnitt des wenigstens einen der Basishalbleiterabschnitte angrenzend an die jeweilige wenigstens eine Nicht-Halbleiter-Monoschicht eine Defektdichte von weniger als oder gleich $1 \times 10^5/cm^2$ hat.

12. Verfahren nach Anspruch 1, wobei das Übergitter wenigstens vier Gruppen von Schichten aufweist.

13. Verfahren nach Anspruch 1, wobei jeder Basishalbleiterabschnitt eine Dicke in einem Bereich von 20-25 Å hat.

14. Verfahren nach Anspruch 7, wobei die Halbleiterdeckschicht eine Dicke in einem Bereich von 70 bis 90 nm hat.

15. Verfahren nach Anspruch 1, ferner aufweisend ein Bilden von Source- und Drain-Bereichen auf dem Substrat an gegenüberliegenden Enden des Übergitters, und ein Bilden eines Gates, das über dem Übergitter liegt.


**Revendications**

1. Procédé de fabrication d'un dispositif semi-conducteur (20), consistant à former sur un substrat (21) un super-réseau (25) comprenant une pluralité d'empilements de groupes de couches (45a-45n), chaque groupe de couches comprenant une pluralité d'empilements de monocouches semi-conductrices de base (46) qui définissent une portion semi-conductrice de base (46a-46n), et comprenant au moins une monocouche non semi-conductrice (50) contrainte à l'intérieur d'un réseau cristallin de portions semi-conductrices de base adjacentes, le procédé étant **caractérisé en ce que** la formation d'au moins l'une des portions semi-conductrices de base consiste à :
réaliser une surcroissance de ladite au moins une portion semi-conductrice de base et graver en retrait ladite au moins une portion semi-conductrice de base en surcroissance.

2. Procédé selon la revendication 1, dans lequel la formation de chaque portion semi-conductrice de base consiste en outre à :

   former un premier ensemble de monocouches semi-conductrices de base (105) ;
   réaliser un recuit thermique (106) ; et
   former un deuxième ensemble de monocouches semi-conductrices de base sur le premier ensemble après le recuit thermique (107).

3. Procédé selon la revendication 2, dans lequel le premier ensemble de monocouches semi-conductrices de base a une épaisseur dans la plage de 6 à 10 Å.

4. Procédé selon la revendication 2, dans lequel le deuxième ensemble de monocouches semi-conductrices de base a une épaisseur dans la plage de 4 à 50 Å.

5. Procédé selon la revendication 1, dans lequel la gravure en retrait de ladite au moins une portion semi-conductrice de base en surcroissance consiste à graver entre 2 et 50 Å de ladite au moins une portion semi-conductrice de base.

6. Procédé selon la revendication 1, dans lequel la gravure en retrait de ladite au moins une portion semi-conductrice de base en surcroissance consiste à graver ladite au moins une portion semi-conductrice de base en surcroissance à une température dans la plage de 500 à 750 °C.

7. Procédé selon la revendication 1, consistant en outre à former une couche de revêtement semi-conductrice (52) sur le super-réseau en formant une première portion de revêtement semi-conductrice sur le substrat à une première température, et en formant une deuxième portion de revêtement semi-conductrice sur la première portion de revêtement semi-conductrice à une deuxième température supérieure ou égale à la première température.

8. Procédé selon la revendication 7, dans lequel la première portion de revêtement semi-conductrice a une épaisseur dans la plage de 4 à 100 Å.

9. Procédé selon la revendication 1, dans lequel les monocouches semi-conductrices de base comprennent des monocouches de silicium.

10. Procédé selon la revendication 1, dans lequel les monocouches non semi-conductrices comprennent de l'oxygène.

11. Procédé selon la revendication 1, dans lequel une portion supérieure de ladite au moins une des portions semi-conductrices de base qui est adjacente à ladite au moins une monocouche non semi-conductrice respective a une densité de défauts inférieure ou égale à $1\times10^{5}/cm^{2}$.

12. Procédé selon la revendication 1, dans lequel le super-réseau comprend au moins quatre groupes de couches.

13. Procédé selon la revendication 1, dans lequel chaque portion semi-conductrice de base a une épaisseur dans la plage de 20 à 25 Å.

14. Procédé selon la revendication 7, dans lequel la couche de revêtement semi-conductrice a une épaisseur dans la plage de 70 à 90 nm.

15. Procédé selon la revendication 1, consistant en outre à former des régions de source et de drain sur le substrat à des extrémités opposées du super-réseau, et à former une grille recouvrant le super-réseau.

FIG. 1

FIG. 2

FIG. 3

4/1 SiO BAND STRUCTURE ABOUT GAMMA POINT

*FIG. 4A*

FIG. *4B*

3/1/5/1 SiO BAND STRUCTURE

FIG. 4C

101 START

102 LOAD AND BAKE WAFER

103 GROW BUFFER

104 DOSE MST LAYER

105 GROW 8 Å OF SPACER "BLANKET" DEPOSITION

106 ANNEAL

107 COOL AND GROW 4-50 Å "BLANKET" DEPOSITION

108 ETCH 2-50 Å

109 DESIRED # OF MST LAYERS ACHIEVED

NO

REPEAT STEPS FOR REQUIRED MST LAYERS

YES

110 GROW EPITAXIALLY CAP LAYER

111 FINISH

100

*FIG. 5*

FIG. 6

FIG. 7

FIG. 8

48
46a
50
47
21

**FIG. 9**

46a
50
47
21

**FIG. 10**

50

46d

50

46c

50

46b

50

46a

50

47

21

FIG. 11

FIG. 12

100'

101' START

102' LOAD AND BAKE WAFER

103' GROW BUFFER

104' DOSE MST LAYER

117' GROW 8-50 Å "SELECTIVE" DEPOSITION

108' ETCH 2-50 Å

REPEAT STEPS FOR REQUIRED MST LAYERS

109' DESIRED # OF MST LAYERS ACHIEVED — NO

YES

110' GROW EPITAXIAL CAP LAYER

111' FINISH

FIG. 13

FIG. 14

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20030057416 A, Currie
- US 20030034529 A, Fitzgerald
- US 6472685 B2, Takagi
- US 4937204 A, Ishibashi
- US 5357119 A, Wang
- US 5683934 A, Candelaria
- US 5216262 A, Tsu
- WO 02103767 A1, Wang, Tsu and Lofgren
- GB 2347520 A, Mears
- US 6376337 B, Wang
- US 2005282330 A
- US 9558939 B, Stephenson

**Non-patent literature cited in the description**

- **TSU.** Phenomena in silicon nanostructure devices. *Applied Physics and Materials Science & Processing,* 06 September 2000, 391-402
- **LUO et al.** Chemical Design of Direct-Gap Light-Emitting Silicon. *Physical Review Letters,* 12 August 2002, vol. 89 (7